# FASCICULE DE BREVET EUROPEEN

(11) **EP 1 456 489 B1**
(45) Date de publication et mention de la délivrance du brevet: **23.08.2006**
(21) Numéro de dépôt: 02792975.1
(22) Date de dépôt: 11.12.2002
(51) Int. Cl.: E05B 17/22, E05B 65/20

(54) **SYSTEME DE DETECTION DE PRESENCE D'UN UTILISATEUR NOTAMMENT POUR VEHICULE AUTOMOBILE**
VORRICHTUNG ZUR DETEKTION DER ANWESENHEIT EINES BENUTZERS, INSBESONDERE FÜR KRAFTFAHRZEUGE
SYSTEM FOR DETECTING THE PRESENCE OF A USER, PARTICULARLY FOR A MOTOR VEHICLE

(30) Priorité: 12.12.2001 FR 0116421
(43) Date de publication de la demande: 15.09.2004
(73) Titulaire: VALEO SECURITE HABITACLE, 94000 Créteil (FR)
(72) Inventeur: GEHIN, Frédéric, F-94000 Creteil (FR)
(74) Mandataire: Rosolen-Delarue, Katell
(86) Numéro de dépôt international: PCT/EP2002/014091
(87) Numéro de publication internationale: WO 2003/050368

(56) Documents cités:
- EP-A- 0 955 431
- EP-A- 1 164 240
- EP-A- 1 235 190
- EP-A- 1 245 761
- CH-A- 531 278
- DE-A- 3 025 841
- DE-A- 19 617 038
- FR-A- 2 809 132
- US-A- 4 107 555
- US-A1- 2001 026 244

## Description

La présente invention concerne un système de détection de présence d'un utilisateur notamment au niveau d'un ouvrant de véhicule automobile.

L'invention concerne plus particulièrement un système de détection de présence d'un utilisateur intégrant un capteur de présence présentant des moyens pour créer localement une zone de non détection de présence.

L'invention est également relative à un système de verrouillage et/ou de déverrouillage d'au moins un ouvrant d'un véhicule automobile intégrant un tel système de détection de présence d'un utilisateur.

Dans le domaine automobile, la poignée d'ouvrant qui servait dans le temps seulement pour transmettre un mouvement mécanique par l'intermédiaire d'une tringlerie à une serrure pour l'ouverture de l'ouvrant a beaucoup évoluée.

En effet, en particulier pour les systèmes d'accès dits "mains libres" permettant le verrouillage et le déverrouillage d'un véhicule automobile sans clé mécanique ni télécommande, la poignée est devenue une interface privilégiée entre l'utilisateur portant un identifiant (par exemple sous la forme d'un badge) et le système embarqué sur le véhicule.

Avec ces systèmes d'accès mains libres, il est devenu nécessaire de définir de nouveaux systèmes d'accès et notamment de nouveaux systèmes permettant la détection d'un utilisateur souhaitant accéder à son véhicule, cette détection de présence de l'utilisateur permettant ensuite d'initier son identification en vue d'autoriser son accès au véhicule.

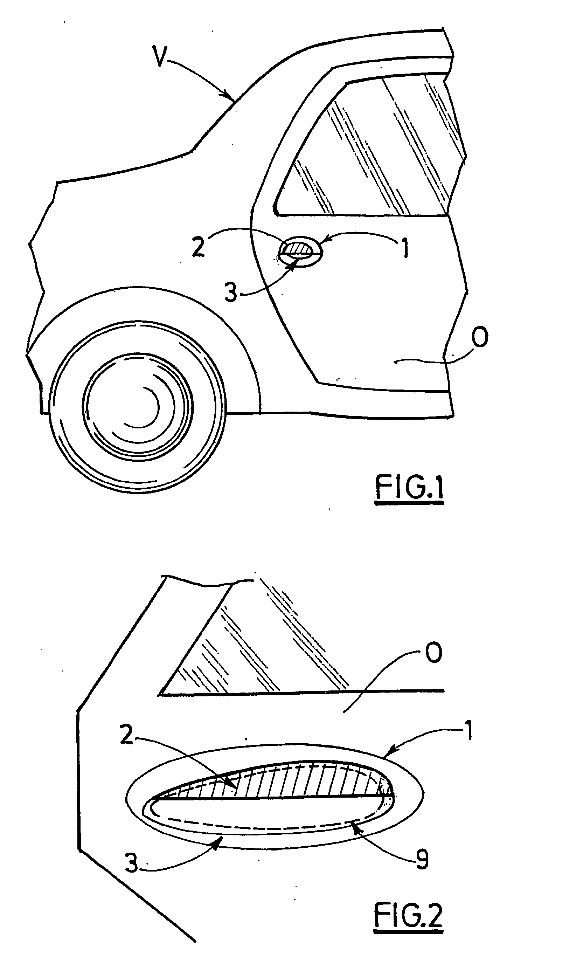

Une poignée utilisée dans un système d'accès mains libres est représentée sur la figure 1. De façon générale, une telle poignée 1 est portée par un ouvrant O de véhicule automobile V et se compose de deux parties, une partie de préhension 2 mobile par rapport à l'ouvrant O et une partie 3 fixe sur la carrosserie de l'ouvrant O. Cette partie fixe est essentiellement décorative et intègre, par exemple, un verrou de secours.

Le document DE-A- 196 17 038 décrit un système de détection de présence, positionné au niveau d'un ouvrant de véhicule automobile équipé d'un système d'accès mains libres, pour détecter l'approche d'un utilisateur au niveau de la poignée de l'ouvrant. Le système de détection de présence comprend un capteur de présence comportant un module électronique de contrôle, une première électrode disposée dans la partie de préhension de la poignée et une seconde électrode disposée au niveau de l'ouvrant.

Le couplage électromagnétique qui s'établit entre les deux électrodes génère une zone de détection de présence de l'utilisateur au niveau de la poignée. Ainsi, lorsque l'utilisateur approche sa main de la poignée en vue d'accéder à son véhicule, sa présence est détectée et son identification, par communication entre le véhicule et l'identifiant porté par l'utilisateur, est initiée.

Le document EP-A-0 955 431 décrit un système de détection de présence selon le préambule de la revendication 1.

Cependant, lorsque les deux électrodes du capteur de présence de l'utilisateur sont toutes deux positionnées au moins en partie au niveau de la poignée, la zone de détection de présence peut être très étendue et notamment englober des zones dans lesquelles aucune détection n'est souhaitée. Par exemple et comme représenté sur la figure 1, pour des raisons d'ergonomie d'utilisation, il est souhaitable d'avoir une détection maximale au niveau de la partie de préhension 2 de la poignée et une détection minimale, voire nulle, au niveau de certaines zones de la partie fixe 3 de la poignée positionnée sur la carrosserie de l'ouvrant.

Par ailleurs, dans certains dispositifs, le capteur de détection de présence est intégré dans un espace réduit notamment au niveau de la poignée, et la zone de détection de présence de l'utilisateur qui lui est associée peut être très étendue et notamment englober le module électronique du capteur. Cet agencement est générateur, au niveau du module électronique, de perturbations électromagnétiques pouvant entraver gravement le fonctionnement du capteur de détection de présence.

Le but de la présente invention est de pallier ces inconvénients et de proposer une solution pour réaliser une gestion de l'étendue de la zone de détection de présence de l'utilisateur de manière à délimiter clairement la zone de détection de présence de l'utilisateur.

A cet effet, l'invention a pour objet un système de détection de présence d'un utilisateur selon la revendication 1.

Le dispositif selon l'invention peut comporter en outre une ou plusieurs des caractéristiques suivantes :
- les moyens pour créer ladite zone de non détection de présence comportent des moyens de masquage de l'électrode de mesure au niveau de la zone de non détection souhaitée ;
- les moyens de masquage sont formés par un élément métallique relié à un potentiel de référence ;
- l'élément métallique est formé par l'électrode de référence du capteur de présence qui est placée localement devant l'électrode de mesure de manière à masquer celle-ci ;
- ladite zone de non détection de présence est créé par lesdites électrodes qui sont rapprochées localement l'une de l'autre de sorte que le couplage électromagnétique qui en résulte augmente ce qui engendre localement une baisse de la sensibilité de détection du capteur de présence ;
- le module de contrôle du capteur de présence comporte un circuit imprimé et la zone de non détection de présence est générée entre ledit circuit imprimé et la zone de détection de présence du capteur de présence;

Un autre but préférentiel de la présente invention consiste à augmenter l'ergonomie de la poignée en proposant d'avoir sur une même poignée, en utilisant un capteur unique, plusieurs zones de détection de présence permettant la commande de fonctions distinctes. Pour ce faire l'invention présente en outre les caractéristiques préférentielles suivantes :
- la zone de non détection de présence de l'utilisateur sépare deux zones de détection de présence pour permettre la commande de deux fonctions distinctes ;
- les deux zones de détection de présence sont de sensibilités différentes ;
- les deux zones de détection de présence et la zone de non détection de présence sont toutes générées par le couplage desdites électrodes de référence et de mesure ;
- le module de contrôle du capteur de présence est intégré dans la poignée ;
- dans la zone de non détection de présence, l'électrode de référence entoure complètement l'électrode de mesure de manière à créer localement un câble coaxial.

De plus, l'invention a pour objet un système de verrouillage et/ou de déverrouillage d'au moins un ouvrant d'un véhicule automobile caractérisé en ce qu'il comporte un système de détection de présence d'un utilisateur selon l'invention.

L'invention sera mieux comprise au cours de la description explicative détaillée qui va suivre en référence aux figures annexées qui représentent :
- Figure 1, une vue partielle de côté d'un véhicule automobile présentant l'emplacement et la structure générale d'une poignée utilisée dans les systèmes d'accès mains libres ;
- Figure 2, une vue partielle de face d'un ouvrant avec une poignée formant le système de détection de présence selon un premier mode de réalisation de l'invention et sur laquelle la zone de détection de présence de l'utilisateur est représentée ;
- Figure 3, une vue arrière de la poignée de la figure 2 intégrant le capteur de détection de présence du système de détection de présence ;
- Figure 4, une vue en coupe transversale de la poignée de la figure 3 selon l'axe A-A' ;
- Figure 5, une vue en coupe transversale de la poignée de la figure 3 selon l'axe B-B' ;
- Figure 6, une vue en coupe transversale d'une poignée selon un second mode de réalisation de l'invention;
- Figure 7, une vue en coupe transversale d'une poignée selon un troisième mode de réalisation de l'invention ;
- Figure 8, une vue arrière d'une poignée intégrant plusieurs capteurs de détection de présence du système de détection de présence selon un quatrième mode de réalisation de l'invention ;
- Figure 9, une vue arrière d'une poignée intégrant un capteur de détection de présence selon un cinquième mode de réalisation du système de détection de présence selon l'invention ;

La figure 2 illustre schématiquement, au niveau d'une poignée 1, utilisée dans les systèmes d'accès mains libres, formée d'une partie de préhension 2 et d'une partie fixe 3 par rapport à la carrosserie, une zone de détection de présence 9 d'un utilisateur générée par un capteur de présence - non représenté - du système de détection de présence selon un premier mode de réalisation de l'invention. Cette zone de détection de présence est centrée sur la ligne médiane de la poignée et englobe au moins une partie de l'élément de préhension 2 et une zone correspondant à une zone d'approche de la main de l'utilisateur lorsque celui-ci s'apprête à saisir l'élément de préhension.

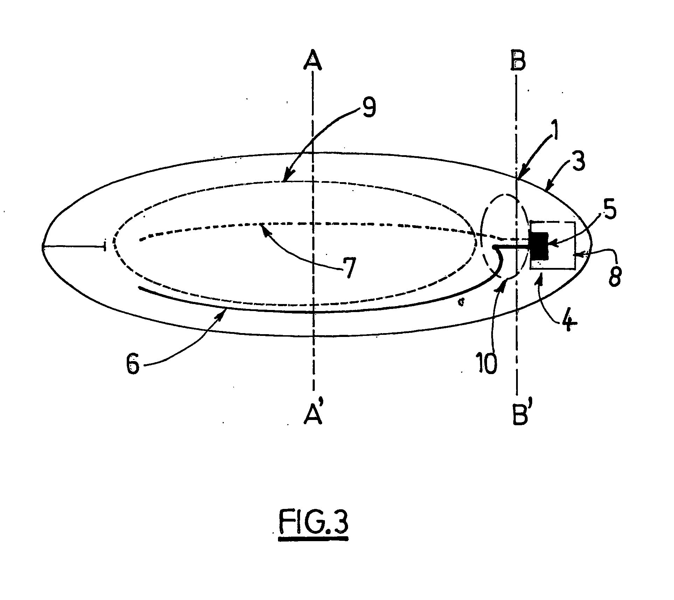

La figure 3 est une vue arrière de la poignée de la figure 2 et présente la partie fixe 3 de la poignée 1 sur laquelle est fixé un capteur de présence 4.

Ce capteur de présence 4 se compose d'un module de contrôle 5, formé de composants électroniques, positionné sur un circuit imprimé 8, d'une électrode de référence 6 et d'une électrode de mesure 7.

Le module de contrôle 5 réalise la gestion électronique de la détection de présence de l'utilisateur et communique avec une unité centrale de gestion intégrée à l'intérieur du véhicule pour la commande de fonctions données. Notamment, dans le cadre d'un véhicule équipé d'un système d'accès mains libres, lors de la détection de présence d'un utilisateur lorsque ce dernier approche sa main de la poignée, le module de contrôle va transmettre cette information à l'unité centrale de gestion pour que celle-ci initie une communication avec l'identifiant porté par l'utilisateur en vue de l'identifier et d'autoriser son accès au véhicule.

Les électrodes de référence 6 et de mesure 7 sont réalisées sous la forme de fils conducteurs fixés selon un procédé connu sur la partie fixe 3 et isolés électriquement par rapport à cette partie lorsque cette dernière est conductrice.

Dans le cas présent, les électrodes ont toutes deux une extrémité libre et sont reliées chacune au module de contrôle mais elles peuvent également avoir des formes très diverses.

L'électrode de référence 6 est positionnée à proximité du bord inférieur de la partie fixe 3 et s'étend longitudinalement sur celle-ci alors que l'électrode de mesure 7 est disposée dans la partie médiane et selon l'axe longitudinal de la partie fixe 3.

Entre les deux électrodes, il s'établit un couplage électromagnétique définissant, au niveau de la poignée, une zone de détection de présence 9 de l'utilisateur.

Les deux électrodes sont généralement disposées de manière assez espacée de façon à ce que le couplage qui s'établit soit suffisamment important pour que le capteur soit d'une sensibilité compatible avec la détection de l'approche d'un utilisateur.

Par contre, à proximité du module de contrôle les électrodes sont positionnées de manière très proche l'une de l'autre de telle sorte que, dans cette zone, le capteur est très peu sensible et engendre une zone 10 dans laquelle une détection de présence ne sera pas possible. Cette zone est appelée zone de non détection de présence.

Ainsi, par rapprochement des deux électrodes à proximité du module de contrôle, une modification locale de la zone de détection de présence est réalisée, ce qui a pour conséquence de créer un zone de non détection de l'utilisateur. Le volume entourant la poignée est alors partagé en une zone de détection de présence 9 de l'utilisateur et une zone de non détection de présence 10.

Dans le mode de réalisation présenté, le module de contrôle du capteur de détection de présence est positionné dans la poignée 1 ce qui a pour effet que le couplage qui s'opère entre les électrodes se situe uniquement au niveau de la poignée.

Par ailleurs, dans un mode de réalisation non représenté, le module de contrôle du capteur de détection de présence peut être positionné dans le véhicule, à un endroit éloigné de la poignée. Le couplage électromagnétique, qui s'établit généralement entre les électrodes, s'opère le long du trajet des électrodes depuis le module de contrôle jusqu'à la poignée où se situe la zone de détection d'approche et il devient alors nécessaire, le long de ce trajet, de créer une zone de non détection de présence. Cette zone de non détection peut être réalisé par rapprochement des électrodes comme exposé précédemment.

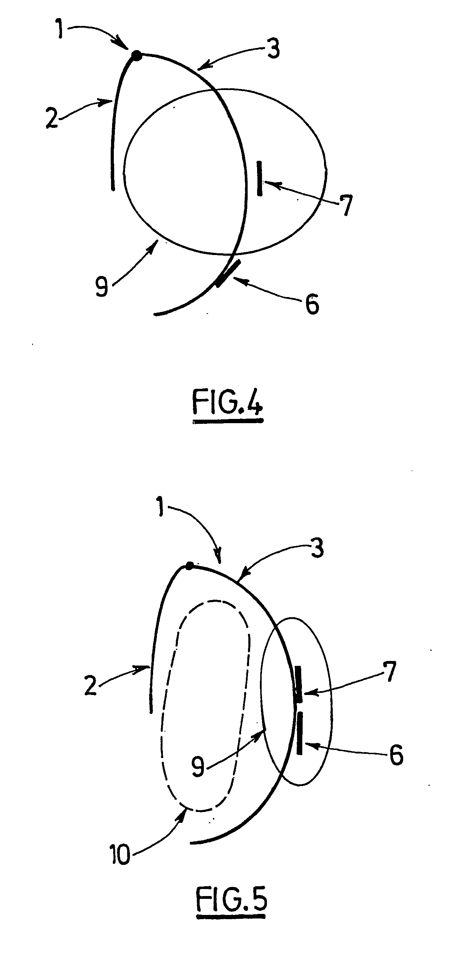

La figure 4 présente une vue en coupe transversale de la figure 3 selon l'axe A-A' sur laquelle le positionnement relatif des électrodes est présenté. L'électrode de référence 6 et l'électrode de mesure 7 s'étendent longitudinalement sur la partie fixe 3 de la poignée 1 et sont positionnées l'une sur la partie médiane et l'autre sur le bord de la partie fixe 3. Le couplage électromagnétique entre ces deux électrodes définit la zone de détection de présence de l'utilisateur 9. Cette zone de détection de présence 9 présente une forme globalement circulaire selon cette coupe et s'étend de part et d'autre de la paroi de la partie fixe de la poignée. Notamment, cette zone de détection s'étend sur une grande partie du volume intérieur défini entre la partie de préhension 2 et la partie fixe 3. Ceci est très avantageux car la présence de l'utilisateur est détectée dès qu'il approche sa main pour saisir la partie de préhension 2 de la poignée en vue d'ouvrir l'ouvrant du véhicule.

La figure 5 est une vue en coupe transversale de la figure 3 selon l'axe B-B', c'est à dire au niveau du module de contrôle du capteur de présence. A proximité du module de contrôle, et conformément à un premier mode de réalisation de l'invention, les électrode de référence 6 et de mesure 7 sont proches l'une de l'autre. Cette disposition locale particulière des électrodes a pour effet que le couplage qui s'établit entre les deux électrodes est faible ce qui génère une zone de détection de présence 9 non seulement de faible volume mais également déplacée vers l'intérieur de l'ouvrant. Ainsi, l'espace entre la partie fixe 3 et la partie de préhension forme localement une zone de non détection de présence 10.

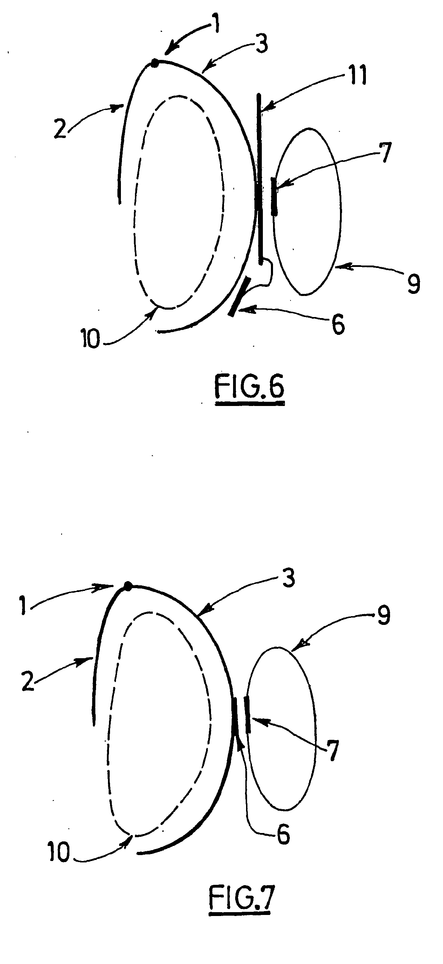

Sur la figure 6, on a représenté une vue en coupe transversale, similaire à la figure 5, d'une poignée muni du système de détection de présence selon un second mode de réalisation de l'invention. Dans ce mode de réalisation, la modification locale de la zone de détection de présence est réalisée par des moyens de masquage de l'électrode de mesure ce qui permet de créer une zone de non détection.

Ainsi, au niveau de la zone où l'on souhaite ne plus avoir de détection, un élément métallique 11 relié à un potentiel de référence est inséré entre l'électrode de mesure et la zone de non détection souhaitée.

Le potentiel de référence est habituellement le potentiel auquel se trouve l'électrode de référence mais comme généralement l'électrode de référence est reliée à la masse, le potentiel de référence peut également être défini comme le potentiel de masse du circuit imprimé 8 portant le module de contrôle 5, ou le potentiel de masse du véhicule.

Ainsi que représenté, l'élément métallique est relié au potentiel de référence ce qui permet de modifier localement la zone de détection de présence par modification du couplage électromagnétique. Le long de cette coupe, la zone de détection de présence de l'utilisateur 9 est donc déplacée vers l'intérieur de l'ouvrant et la zone située, au niveau de la poignée, entre la partie de préhension 2 et la partie fixe 3 devient une zone de non détection de présence 10.

La figure 7 présente une vue en coupe transversale d'une poignée équipée d'un système selon un mode de réalisation préférentiel de l'invention. Dans ce mode de réalisation l'élément métallique 11 de masquage de l'électrode de mesure 7 est directement réalisé par l'électrode de référence 6 qui est déplacée et insérée entre l'électrode de mesure et la zone dans laquelle on ne souhaite pas détecter l'utilisateur. Ainsi, à proximité du module de contrôle, l'électrode de référence masque l'électrode de mesure pour déplacer la zone de détection de présence de l'utilisateur. En résumé, le long de l'axe de coupe, une zone de non détection de présence 10 est créée et la zone de détection de présence 9 de l'utilisateur est déplacée vers l'intérieur de l'ouvrant.

Cette disposition avantageuse et l'utilisation de l'électrode de référence comme moyen de masquage de l'électrode de mesure permet de contrôler l'étendue de la zone de détection de présence de l'utilisateur au niveau de la poignée et de gérer sa localisation.

Par ailleurs, il existe actuellement des dispositifs dans lesquels plusieurs capteurs de détection de présence sont intégrés dans un espace réduit notamment au niveau de la poignée. Dans ces dispositifs, le fait d'avoir des zones de détection de présence très étendues et non contrôlées est générateur de perturbations pouvant entraver gravement le fonctionnement des différents capteurs de présence.

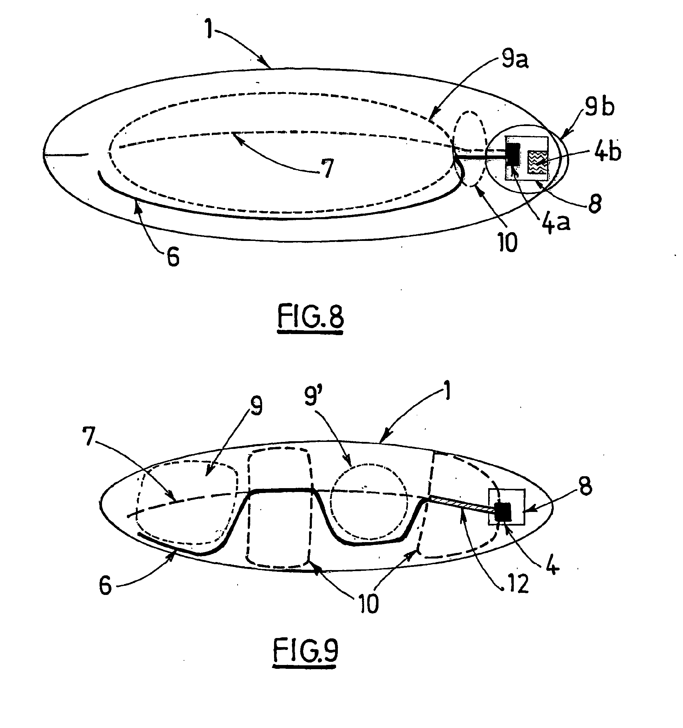

Le mode de réalisation de l'invention présenté à la figure 8, représentant une vue arrière d'une poignée dans laquelle plusieurs capteurs de détection de présence sont intégrés, permet de surmonter ce problème

Dans ce mode de réalisation, la poignée 1 est pourvue de plusieurs capteurs de détection de présence 4a et 4b dont les zones de détections sont distinctes.

Ces capteurs se déclinent en :
- un capteur d'approche 4a permettant de détecter l'approche d'un utilisateur au niveau de la poignée ; et
- un capteur tactile 4b permettant de détecter une action volontaire de toucher de l'utilisateur au niveau de la poignée.

De manière générale, le capteur d'approche est utilisé pour détecter l'approche de l'utilisateur en vue d'initier une communication entre l'identifiant et le système embarqué dans le véhicule alors que le capteur tactile est utilisé en vue de détecter une action volontaire de l'utilisateur lorsqu'il souhaite verrouiller le véhicule

Ces deux capteurs de présence fonctionnent selon le même principe, mais présentent des sensibilités différentes dépendant de la forme de leurs électrodes et/ou de leur positionnement relatif. En effet, lorsque l'on rapproche les électrodes, le couplage entre celles-ci augmente et la sensibilité résultant de ce couplage baisse car la perturbation nécessaire pour engendrer une détection devra être plus importante.

Le capteur d'approche 4a possède des électrodes de référence 6 et de mesure 7 s'étendant longitudinalement sur la partie fixe 3 de la poignée et présente une sensibilité importante à la détection de présence alors que le capteur tactile 4b présente une sensibilité plus faible, nécessitant un toucher de l'utilisateur, associée à des électrodes localisées au niveau du circuit imprimé 8.

Ainsi, la zone de détection de présence 9a du capteur d'approche est très étendue et présente une forme oblongue alors que la zone de détection de présence 9b du capteur tactile est plus réduite et centrée sur le circuit imprimé 8.

Selon ce mode de réalisation de l'invention, les deux zones de détection de présence 9a et 9b sont séparées par une zone de non détection de présence de l'utilisateur 10 créée par rapprochement local des deux électrodes du capteur d'approche. De cette manière, les zones de détection d'approche 9a et de détection tactile 9b sont bien séparées et tout disfonctionnement est évité.

Ceci est très avantageux car on empêche ainsi une interpénétration des zones de détection de présence associées à ces deux capteurs qui permettent la commande de fonctions très différentes.

Dans le mode de réalisation décrit, les électrodes du capteur d'approche sont des électrodes filaires réalisées sous la forme de fils conducteurs et les électrodes du capteur tactile prennent la forme de pistes conductrices disposées sur le circuit imprimé. Bien entendu, les électrodes de ces capteurs de détection de présence peuvent être réalisées sous d'autres formes que celles présentées, et notamment sous la forme de fines lames métalliques.

Les électrodes, lorsqu'elles sont réalisées sous forme filaire, sont fixées, par exemple à l'aide d'un adhésif ou d'une colle, sur la partie fixe 3 de la poignée 1 qui est non conductrice ou par rapport à laquelle les électrodes sont isolées.

La figure 9 est une vue arrière d'une poignée muni d'un système selon un cinquième mode de réalisation de l'invention et intégrant un capteur unique de détection de présence présentant plusieurs zones de détections de présence.

Dans ce mode de réalisation de l'invention, le capteur de présence 4 présente deux zones de détection de présence 9, 9' séparées par une zone de non détection de présence 10 créée par modification locale de la zone initiale de détection de présence de l'utilisateur.

Dans le cas présent, la zone de non détection est crée par masquage locale de l'électrode de mesure et sépare la zone de détection de présence initiale en deux zones de détection de présence 9, 9' permettant la commande, à l'aide d'un capteur de présence unique, de deux fonctions distinctes au niveau du véhicule.

En effet, lors d'une détection de présence d'un utilisateur au niveau de la poignée, un traitement électronique au niveau du module de contrôle du capteur permet de savoir dans quelle zone de détection de présence l'utilisateur a été détecté et ainsi quelle fonction a été commandée par l'utilisateur. Le module électronique active ensuite la fonction commandée.

La poignée présente donc deux zones de détection de présence de l'utilisateur avec, par exemple, une zone pour la commande de déverrouillage de l'ensemble des ouvrants du véhicule et une zone pour la commande du déverrouillage de l'ouvrant conducteur. L'utilisateur a donc le choix, dans le cadre d'un capteur de présence sensible à l'approche, d'approcher sa main vers l'une ou l'autre des zones de détection de présence pour commander le déverrouillage de l'ensemble des ouvrants ou seulement de l'ouvrant conducteur.

L'avantage est manifestement de pouvoir commander plusieurs fonctions à l'aide d'un seul capteur de détection de présence en créant une pluralité de zones de détection de présence.

Dans la figure présentée les deux zones de détection de présence ont des tailles différentes du fait d'une différence de couplage entre l'électrode de référence et l'électrode de mesure. En effet, l'électrode de référence et l'électrode de mesure ont un écartement différent dans les deux zones de détection de présence. Ainsi, chaque zone de détection de présence possède une sensibilité différente permettant la commande, grâce à un seul capteur de détection de présence, de plusieurs fonctions différentes.

Par ailleurs, entre le capteur de détection de présence 4 et la première zone de détection de présence, une zone de non détection de présence est réalisée par modification locale de la zone initiale de détection de présence. Dans cette zone de non détection de présence, l'électrode de référence entoure de préférence complètement l'électrode de mesure de manière à former localement un câble coaxial 12. Cette disposition peut être également appliquée entre les deux zones de détection 9 et 9'.

Ainsi, les zones de non détection peuvent être créées par réalisation locale d'un câble coaxial mais aussi par rapprochement des électrodes ou par masquage de l'électrode de mesure.

Grâce à l'invention, on a réalisé un système permettant la gestion de l'étendue et de la localisation d'au moins une zone de détection de présence de l'utilisateur.

Le système selon l'invention est généralement intégré dans une poignée d'ouvrant et peut être mis en oeuvre dans un système de verrouillage et/ou déverrouillage d'au moins un ouvrant de véhicule et notamment dans le cadre de véhicule à accès mains libres.

## Revendications

1. Système de détection de présence d'un utilisateur notamment au niveau d'un ouvrant de véhicule automobile comprenant,
- une poignée (1) portée par l'ouvrant;
- un capteur de présence (4) de l'utilisateur comportant un module de contrôle (5), au moins une électrode de mesure (7) et au moins une électrode de référence (6) ;
lesdites électrodes (6,7) étant chacune reliée au module de contrôle (5) et positionnée au moins en partie dans la poignée (1);
un couplage électromagnétique s'établissant entre lesdites électrodes (6,7) pour définir le long du trajet des électrodes (6,7), une zone de détection de présence (9) de l'utilisateur,
la détection de présence de l'utilisateur au niveau de ladite zone de détection (9) permettant la commande d'au moins une fonction donnée au niveau du véhicule,
**caractérisé en ce qu'**il comprend également des moyens, au niveau des électrodes (6,7), modifiant localement ledit couplage électromagnétique de manière à créer au moins une zone de non détection de présence (10) de l'utilisateur par modification locale de la zone de détection de présence (a), ou **en ce que** les électrodes (6,7) sont positionées de façon particulière afin de modifier localement ledit couplage électromagnétique de manière à créer au moins une zone de non détection de présence (10) de l'utilisateur par modification locale de la zone de détection de présence (9).

2. Système de détection de présence selon la revendication 1, **caractérisé en ce que** les moyens pour créer ladite zone de non détection de présence (10) comportent des moyens de masquage (11) de l'électrode de mesure (7) au niveau de la zone de non détection souhaitée.

3. Système de détection de présence selon la revendication 2, **caractérisé en ce que** les moyens de masquage sont formés par un élément métallique (11) relié à un potentiel de référence.

4. Système de détection de présence selon la revendication 3, **caractérisé en ce que** l'élément métallique (11) est formé par l'électrode de référence (6) du capteur de présence (4) qui est placée localement devant l'électrode de mesure (7) de manière à masquer celle-ci.

5. Système de détection de présence selon la revendication 1, **caractérisé en ce que** ladite zone de non détection de présence (10) est créé par lesdites électrodes (6,7) qui sont rapprochées localement l'une de l'autre de sorte que le couplage électromagnétique qui en résulte augmente ce qui engendre localement une baisse de la sensibilité de détection du capteur de présence.

6. Système de détection de présence selon l'une quelconque des revendications 1 à 5, **caractérisé en ce que** le module de contrôle (5) du capteur de présence comporte un circuit imprimé (8) et **en ce que** la zone de non détection de présence (10) est générée entre ledit circuit imprimé (8) et la zone de détection de présence (9) du capteur de présence (4).

7. Système de détection de présence selon l'une des revendications 1 à 5, **caractérisé en ce que** la zone de non détection de présence (10) de l'utilisateur sépare deux zones de détection de présence (9, 9') pour permettre la commande de deux fonctions distinctes.

8. Système de détection de présence selon la revendication 7, **caractérisé en ce que** les deux zones de détection de présence (9, 9') sont de sensibilités différentes.

9. Système de détection de présence selon la revendication 7 ou 8, **caractérisé en ce que** les deux zones de détection de présence (9, 9') et la zone de non détection de présence (10) sont toutes générées par le couplage desdites électrodes de référence et de mesure (6,7),

10. Système de détection de présence selon l'une quelconque des revendications précédentes, **caractérisé en ce que** le module de contrôle (5) du capteur de présence (4) est intégré dans la poignée (1).

11. Système de détection de présence selon l'une quelconque des revendications 6 à 10, **caractérisé en ce que**, dans la zone de non détection de présence (10), l'électrode de référence (6) entoure complètement l'électrode de mesure (7) de manière à créer localement un câble coaxial (12).

12. Système de verrouillage et/ou de déverrouillage d'au moins un ouvrant d'un véhicule automobile **caractérisé en ce qu'**il comporte un système de détection de présence d'un utilisateur selon l'une quelconque des revendications 1 à 11.

## Claims

1. System for detection of presence of a user, in particular at a motor vehicle door, comprising:
- a handle (1) supported by the door;
- a sensor for the presence (4) of the user, comprising a control module (5), at least one measuring electrode (7) and at least one reference electrode (6),
the said electrodes (6, 7) each being connected to the control module (5) and positioned at least partly in the handle (1),
electromagnetic coupling which is established between the said electrodes (6, 7) in order to define an area of detection of presence (9) of the user along the path of the electrodes (6, 7);
detection of the presence of the user at the said area of detection (9), thus permitting control of at least one data function on the vehicle,
**characterised in that** it also comprises means on the electrodes (6, 7) to modify locally the said electromagnetic coupling, such as to create at least one area of non-detection of presence (10) of the user by local modification of the area of detection of presence (9), or in that the electrodes (6, 7) are positioned in a particular manner in order to modify locally the said electromagnetic coupling, such as to create at least one area of non-detection of presence (10) of the user by local modification of the area of detection of presence (9).

2. System for detection of presence according to claim 1, **characterised in that** the means for creating the said area of non-detection of presence (10) comprise means (11) for masking the measuring electrode (7) at the area of non-detection required.

3. System for detection of presence according to claim 2, **characterised in that** the masking means are formed by a metal element (11) connected to a reference potential.

4. System for detection of presence according to claim 3, **characterised in that** the metal element (11) is formed by the reference electrode (6) of the presence sensor (4) which is placed locally in front of the measuring electrode (7) such as to mask the latter.

5. System for detection of presence according to claim 1, **characterised in that** the said area of non-detection of presence (10) is created by the said electrodes (6, 7) which are brought towards one another locally such that the resulting electromagnetic coupling is increased, which generates locally a decrease in the sensitivity of detection of the presence sensor.

6. System for detection of presence according to any one of claims 1 to 5, **characterised in that** the control module (5) of the presence sensor comprises a printed circuit (8), and **in that** the area of non-detection of presence (10) is generated between the said printed circuit (8) and the area of detection of presence (9) of the presence sensor (4).

7. System for detection of presence according to any one of claims 1 to 5, **characterised in that** the area of non-detection of presence (10) of the user separates two areas of detection of presence (9, 9'), in order to permit control of two distinct functions.

8. System for detection of presence according to claim 7, **characterised in that** the two areas of detection of presence (9, 9') have different sensitivities.

9. System for detection of presence according to claim 7 or claim 8, **characterised in that** the two areas of detection of presence (9, 9') and the area of non-detection of presence (10) are all generated by the coupling of the said reference and measuring electrodes (6, 7).

10. System for detection of presence according to any one of the preceding claims, **characterised in that** the control module (5) of the presence sensor (4) is incorporated in the handle (1).

11. System for detection of presence according to any one of claims 6 to 10, **characterised in that**, in the area of non-detection of presence (10), the reference electrode (6) surrounds the measuring electrode (7) completely, such as to create locally a coaxial cable (12).

12. System for locking and/or unlocking at least one door of a motor vehicle, **characterised in that** it comprises a system for detection of presence of a user according to any one of claims 1 to 11.

## Patentansprüche

1. System zum Erfassen der Anwesenheit eines Benutzers insbesondere in der Nähe einer Kraftfahrzeugtür, mit
- einem von der Tür getragenen Griff (1),
- einem Benutzeranwesenheitssensor (4) mit einem Kontrollmodul (5), zumindest einer Messelektrode (7) und zumindest einer Bezugselektrode (6),
wobei die Elektroden (6, 7) jeweils mit dem Kontrollmodul (5) verbunden sind und zumindest teilweise in dem Griff (1) positioniert sind,
wobei eine elektromagnetische Kopplung zwischen den Elektroden (6, 7) entsteht, um entlang der Wegstrecke der Elektroden (6, 7) einen Bereich (9) zum Erfassen der Anwesenheit des Benutzers zu definieren,
wobei die Erfassung der Anwesenheit des Benutzers in der Nähe des Erfassungsbereichs (9) die Steuerung zumindest einer gegebenen Funktion in der Nähe des Fahrzeugs ermöglicht,
**dadurch gekennzeichnet, dass** es in der Nähe der Elektroden (6, 7) auch Mittel enthält, welche die elektromagnetische Kopplung bereichsweise so ändern, dass zumindest ein Bereich (10) der Nichterfassung der Anwesenheit des Benutzers durch bereichsweise Änderung des Anwesenheiterfassungsbereichs (9) entsteht, oder dass die Elektroden (6, 7) in besonderer Weise positioniert sind, um die elektromagnetische Kopplung bereichsweise so zu ändern, dass zumindest ein Bereich (10) der Nichterfassung der Anwesenheit des Benutzers durch bereichsweise Änderung des Anwesenheiterfassungsbereichs (9) entsteht.

2. Anwesenheiterfassungssystem nach Anspruch 1, **dadurch gekennzeichnet, dass** die Mittel zum Schaffen des Anwesenheitnichterfassungsbereichs (10) Mittel (11) zum Verdecken der Messelektrode (7) in der Nähe des gewünschten Nichterfassungsbereichs enthalten.

3. Anwesenheiterfassungssystem nach Anspruch 2, **dadurch gekennzeichnet, dass** die Verdeckmittel von einem Metallteil (11) gebildet werden, das mit einem Bezugspotential verbunden ist.

4. Anwesenheiterfassungssystem nach Anspruch 3, **dadurch gekennzeichnet, dass** das Metallteil (11) aus einer Bezugselektrode (6) des Anwesenheitssensors (4) gebildet ist, der bereichsweise vor die Messelektrode (7) positioniert ist, so dass er diese verdeckt.

5. Anwesenheiterfassungssystem nach Anspruch 1, **dadurch gekennzeichnet, dass** der Anwesenheitnichterfassungsbereich (10) von den Elektroden (6, 7) gebildet wird, die einander bereichsweise angenähert sind, so dass die sich daraus ergebene elektromagnetische Kopplung verstärkt wird, wodurch bereichsweise eine Verminderung der Erfassungsempfindlichkeit des Anwesenheitssensors hervorgerufen wird.

6. Anwesenheiterfassungssystem nach einem der Ansprüche 1 bis 5, **dadurch gekennzeichnet, dass** das Kontrollmodul (5) des Anwesenheitssensors eine gedruckte Schaltung (8) enthält und dass der Anwesenheitnichterfassungsbereich (10) zwischen gedruckter Schaltung (8) und Anwesenheiterfassungsbereich (9) des Anwesenheitssensors (4) geschaffen wird.

7. Anwesenheiterfassungssystem nach einem der Ansprüche 1 bis 5, **dadurch gekennzeichnet, dass** der Bereich (10) zum Nichterfassen des Benutzers die beiden Anwesenheiterfassungsbereiche (9, 9') trennt, um die Steuerung zweier unterschiedlicher Funktionen zu gestatten.

8. Anwesenheiterfassungssystem nach Anspruch 7, **dadurch gekennzeichnet, dass** die beiden Anwesenheiterfassungsbereiche (9, 9') eine unterschiedliche Empfindlichkeit haben.

9. Anwesenheiterfassungssystem nach Anspruch 7 oder 8, **dadurch gekennzeichnet, dass** die beiden Anwesenheiterfassungsbereiche (9, 9') und der Anwesenheitnichterfassungsbereich (10) alle über die Kopplung der Bezugs- und der Messelektrode (6, 7) geschaffen werden.

10. Anwesenheiterfassungssystem nach einem der vorangehenden Ansprüche, **dadurch gekennzeichnet, dass** das Kontrollmodul (5) des Anwesenheitssensors (4) im Griff (1) integriert ist.

11. Anwesenheiterfassungssystem nach einem der Ansprüche 6 bis 10, **dadurch gekennzeichnet, dass** in dem Anwesenheitnichterfassungsbereich (10) die Bezugselektrode (6) die Messelektrode (7) vollständig umschließt, so dass bereichsweise ein Koaxialkabel (12) entsteht.

12. System zum Verriegeln und/oder Entriegeln zumindest einer Kraftfahrzeugtür, **dadurch gekennzeichnet, dass** es ein System zum Erfassen der Anwesenheit eines Benutzers nach einem der Ansprüche 1 bis 11 enthält.
